# EUROPÄISCHE PATENTSCHRIFT

(11) **EP 1 149 421 B1**
(45) Veröffentlichungstag und Bekanntmachung des Hinweises auf die Patenterteilung: **10.05.2006**
(21) Anmeldenummer: 99966810.6
(22) Anmeldetag: 01.12.1999
(51) Int. Cl.: H01L 27/115, H01L 21/8247, H01L 29/51

(54) **FEMFET-VORRICHTUNG UND VERFAHREN ZU DEREN HERSTELLUNG**
FEMFET DEVICE AND METHOD FOR PRODUCING SAME
DISPOSITIF FEMFET ET SON PROCEDE DE PRODUCTION

(30) Priorität: 10.12.1998 DE 19857038
(43) Veröffentlichungstag der Anmeldung: 31.10.2001
(73) Patentinhaber: Infineon Technologies AG, 81669 München (DE)
(72) Erfinder: SCHLÖSSER, Till, D-81825 München (DE); HANEDER, Thomas, Peter, D-81549 München (DE)
(74) Vertreter: Reinhard - Skuhra - Weise & Partner
(86) Internationale Anmeldenummer: PCT/DE1999/003817
(87) Internationale Veröffentlichungsnummer: WO 2000/035019

(56) Entgegenhaltungen:
- DE-A- 19 739 673
- US-A- 3 731 163
- US-A- 5 596 214
- US-A- 5 619 051

## Beschreibung

Die vorliegende Erfindung betrifft eine FEMFET-Vorrichtung (FEMFET = ferroelectric memory field-effect transistor bzw. ferroelektrischer Speicher-Feldeffekttransistor) gemäß dem Oberbegriff des Anspruches 1, welche aus der US-A-5,619,051 bekannt ist.

Die EP 0 566 585 B1 offenbart allgemein eine Speicherzellenanordnung, welche als Speicherzellen Feldeffekttransistoren mit einer ferroelektrischen Schicht (FEMFETs) im Gatedielektrikum aufweist. Insbesondere wird dort empfohlen, das Gatedielektrikum als Mehrschichtdielektrikum auszubilden, wobei eine erste SiO₂-Schicht auf dem Substrat vorgesehen wird, darüber die ferroelektrische Schicht un darüber eine zweite SiO₂-Schicht, auf der die Gateelektrode, z.B. aus polykristallinem Silizium, aufgebracht wird.

Seit kurzem werden in der Mikroelektronik ferroelektrische Materialien, meist Perowskite, zur Herstellung von nicht-flüchtigen Speicherelementen eingesetzt. Durch die spontane und remanente elektrische Polarisation dieser Materialien ist es möglich, Ladung und damit Information nicht-flüchtig zu speichern. Üblicherweise werden die ferroelektrischen Materialien dabei entweder als dielektrieche Schicht in einem Kondensator oder im Gatestapel eines Feldeffekttransistors eingesetzt.

Ein Feldeffekttransistor mit ferroelektrischem Gatematerial ist die Ausgangsbasis für den Bau von z.B. nicht-flüchtigen 1-Transistor-Speicherzellen mit extrem kurzen Schreib-, Lösch- (im Gegensatz zu EEPROMs) und Lesezeiten. Durch die remanente Polarisation des ferroelektrischen Materials über dem Kanal eines Feldeffekttransistors und das davon ausgehende elektrische Feld können im darunter liegenden Halbleitersubstrat (Kanal) unterschiedliche Zustände, wie Inversion oder Akkumulation "gespeichert" werden. Der Betriebszustand und die Leitfähigkeit des Transistors können also durch das Ferroelektrikum nicht-flüchtig verändert werden. Diesem Umstand ist es zu verdanken, daß mit einem solchen Bauelement Information gespeichert bzw. logische Zustände unterschieden werden können. Das Speichern von Information geschieht durch das Anlegen einer ausreichend großen Spannung an das ferroelektrische Material. Dadurch kann die Polarisation des Materials in geeigneter Weise verändert (umgedreht) werden.

Die der vorliegenden Erfindung zugrundeliegende Problematik besteht allgemein darin, daß davon abgesehen werden kann, das ferroelektrische Material unmittelbar über dem Kanal, d.h. direkt auf dem Halbleitersubstrat abzuscheiden, um funktionierende Transistoren bzw. Transistoren mit guten elektrischen Eigenschaften zu erhalten.

Schlechte Grenzflächeneigenschaften zerstören die Funktion des Bauelements.

Es ist deshalb vorgeschlagen worden, zwischen dem Substrat und dem ferroelektrischem Material eine oder mehrere zusätzliche dielektrische Schichten (sogenannte dielektrische Pufferschichten) vorzusehen. Sie sollen einerseits eine ausreichend gute Grenzfläche zum Silizium und damit gute Transistoreigenschaften garantieren, sollen andererseits aber das Verhalten des Bauelements möglichst wenig beeinflussen.

Ferroelektrische Materialien weisen im allgemeinen eine sehr große dielektrische Suszeptibilität (große relative Dielektrizitätskonstante εᵣ von einigen 100 bis 1000) auf.

Beim ferroelektrischen Feldeffekttransistor bilden das Halbleitersubstrat, die dielektrische Pufferschicht und das Ferroelektrikum eine Reihenschaltung unterschiedlich großer Kapazitäten. Damit man die Polarisation des ferroelektrischen Materials mit kleinen Spannungen verändern kann, ist es deshalb nötig, daß die dielektrische Pufferschicht ein möglichst großes εᵣ und eine geringe Schichtdicke d aufweist, da sonst der größte Teil einer an diese Schichtkombination angelegten Spannung über der Zwischenschicht und nicht über dem Ferroelektrikum abfällt. Dies führt sonst zu großen Programmierspannungen und der Gefahr elektrischer Durchbrüche in den Schichten. Insbesondere ist darauf zu achten, daß die Bildung von natürlichem oder prozeßbedingtem SiO₂ an der Grenzfläche Halbleitersubstrat - Zwischenschicht vermieden wird, da SiO₂ aufgrund seines kleinen εᵣ (großer Spannungsabfall) die Eigenschaften des Transistors verschlechtert, d.h. zu größeren Programmierspannungen führt. Um diese Probleme zu umgehen, wurde vorgeschlagen stabile Oxide mit großer dielektrischer Suszeptibilität, wie beispielsweise CeO₂, Y₂O₃ oder ZrO₂, als dielektirsche Pufferschicht zu verwenden.

Als nachteilhaft bei den obigen bekannten Ansätzen hat sich die Tatsache herausgestellt, daß Diffusionsprozesse zwischen einzelnen Bestandteilen des ferroelektrischen Mate- rials und dem Halbleitersubstrat die Transistoreigenschaften ebenfalls drastisch verschlechtern. Dem könnte man zwar durch eine Erhöhung der Schichtdicke d der dielektrischen Pufferschicht begegnen doch würde dies, wie oben erwähnt, die Gefahr elektrischer Durchbrüche vergrößern.

Daher ist es Aufgabe der vorliegenden Erfindung, die eingangs definierte FEMFET-Vorrichtung derart zu verbessern, daß die störenden Diffusionsprozesse beseitigt werden, ohne die elektrischen Eigenschaften zu verschlechtern.

Erfindungsgemäß wird diese Aufgabe durch die in Anspruch 1 angegebene FEMFET-Vorrichtung sowie das entsprechende Herstellungsverfahren nach Anspruch 6 gelöst.

Die erfindungsgemäße FEMFET-Vorrichtung weist gegenüber den bekannten Lösungsansätzen den Vorteil auf, daß keine störende Diffusion mehr auftritt und gleichzeitig der Gatestapel nicht zu dick wird.

Die der vorliegenden Erfindung zugrundeliegende Idee besteht darin, daß der Gatestapel zumindest eine dünne Diffusionsbarrierenschicht aufweist, welche zwischen der untersten ferroelektrischen Schicht und dem Halbleitersubstrat angeordnet ist. Die dünne Diffusionsbarrierenschicht ist in Abhängigkeit vom verwendeten Ferroelektrikum derart gestaltet, daß sie eine Ausdiffusion von Bestandteilen aus der oder den ferroelektrischen Schichten in das Halbleitersubstrat im wesentlichen verhindert.

In den Unteransprüchen finden sich vorteilhafte Weiterbildungen und Verbesserungen der in Anspruch 1 angegebenen FEMFET-Vorrichtung.

Gemäß einer weiteren bevorzugten Weiterbildung ist die Siliziumnitridschicht direkt auf dem Halbleitersubstrat vorgesehen. Die üblichen ferroelektrischen Transistoren basieren ausschließlich auf der Verwendung keramischer Oxide als dielektrischer Zwischenschicht. Siliziumnitrid in Verbindung mit einer vorausgehenden Reinigung des Substrats (Entfernen des natürlichen Oxids) bietet als an dieser Stelle neues Material viele Vorteile, insbesondere eine gute Qualität der Grenzfläche, eine ausreichend große relative Dielektrizitätskonstante und schließlich seine hervorragende Wirkung als Diffusionsbarriere schon bei sehr geringen Schichtdicken.

Gemäß einer weiteren bevorzugten Weiterbildung ist die dielektrische Pufferschicht direkt auf dem Halbleitersubstrat vorgesehen. Dies ist dann zweckmäßig, wenn die dielektrische Pufferschicht und das Halbleitersubstrat gute Grenzflächeneigenschaften aufweisen.

Ausführungsbeispiele der Erfindung sind in den Zeichnungen dargestellt und in der nachfolgenden Beschreibung näher erläutert .

Es zeigen:
- Fig. 1: eine schematische Darstellung einer FEMFET-Vorrichtung, die dem Verständnis der vorliegenden Erfindung dient; und
- Fig. 2: eine schematische Darstellung einer FEMFET-Vorrichtung gemäß einer Ausführungsform der vorliegenden Erfindung.

In den Figuren bezeichnen gleiche Bezugszeichen gleiche oder funktionsgleiche Elemente.

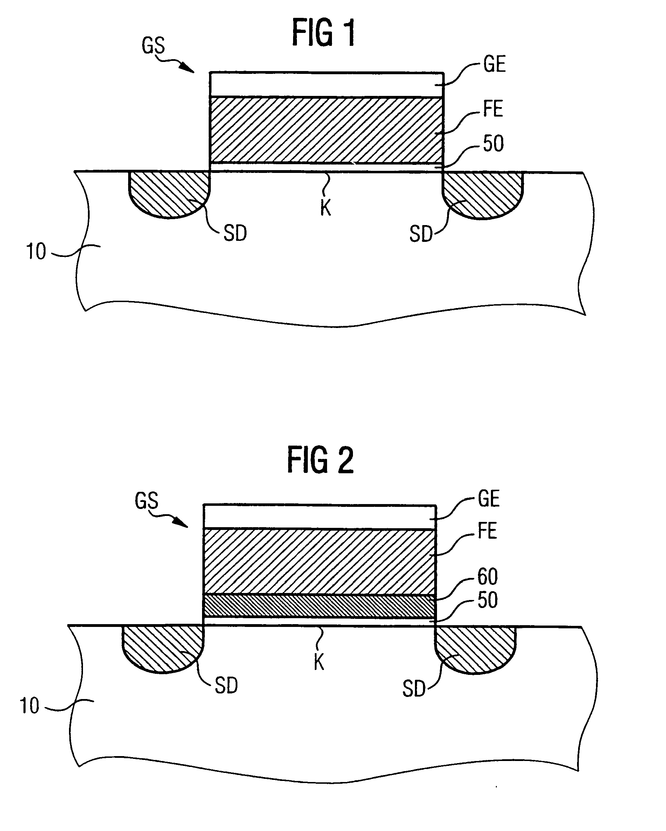

Fig. 1 ist eine schematische Darstellung einer FEMFET-Vorrichtung, die dem Verständnis der vorliegenden Erfindung dient.

In Fig. 1 bezeichnen 10 ein Halbleitersubstrat, S einen Sourcebereich, D einen Drainbereich, K einen Kanalbereich, GS einen Gatestapel, 50 eine Diffusionsbarrierenschicht, FE eine ferroelektrische Schicht und GE eine Gateelektrode.

Im Rahmen dieser FEMFET-Vorrichtung wird eine Kombination aus hochreiner Grenzfläche und Siliziumnitrid (Si₃N₄) als Diffusionsberrierenschicht vorgeschlagen. In modernen Cluster Tools kann auf das Entfernen des auf dem Halbleitersubstrat 10 befindlichen natürlichen Oxids (SiO₂) mit Flußsäure-Dampf an der Substratoberfläche unmittelbar das Abscheiden von Si₃N₄ folgen, ohne das Halbleitersubstrat 10 zwischen beiden Schritten einer oxidierenden Atmosphäre auszusetzen. Dadurch ist es möglich, Si₃N₄ direkt auf dem Halbleitersubstrat 10 abzuscheiden, ohne die Bildung von Oxid, insbesondere SiO₂, in Kauf nehmen zu müssen, wie dies bei Verwendung keramischer Oxide (CeO₂, Y₂O₃ oder ZrO₂) der Fall sein kann.

Im Vergleich zu SiO₂ besitzt Si₃N₄ ein um den Faktor zwei grö-ßeres εᵣ von ca. 7,9. Bei ansonsten gleichen Bedingungen reduziert sich damit die Programmierspannung des Transistors im Vergleich zu SiO₂ als Zwischenschicht um den Faktor zwei. Gleichzeitig ist die Qualität der Grenzfläche Si - Si₃N₄ besser als die der Grenzfläche zwischen Silizium und einem keramischen Oxid. Darüber hinaus stellt Si₃N₄ eine extrem gute Diffusionsbarriere zwischen dem Halbleitersubstrat 10 und dem ferroelektrischem Material FE dar und wird beim Aufbringen dieses Materials kaum oxidiert. Die Grenzfläche Silizium - Diffusionsbarrierenschicht wird deshalb durch diffundierende Komponenten des ferroelektrischen Materials nicht beeinflußt. Um sehr kleine Programmierspannungen zu erreichen, kann das Siliziumnitrid sehr dünn (einige nm) gemacht werden.

Die Herstellung eines solchen ferroelektrischen Transistors nach Fig. 1 mit Siliziumnitrid als Diffusionsbarrierenschicht erfolgt ansonsten sehr ähnlich wie die Herstellung konventioneller MOSFETs. Auf dem halbleitenden Substrat werden aktive und nicht-aktive Gebiete z.B. durch die LO-COS-Technik definiert. Nach der Implantation der Wannen wird die freiliegende Siliziumoberfläche z.B. in einem Cluster Tool mit HF-Dampf oder N2O-Dampf gereinigt. Anschließend wird z.B. mit einem RTN-Verfahren und/oder mit einem CVD-Prozeß dichtes Siliziumnitrid (Si₃N₄) in der gewünschten Dicke auf der gereinigten Oberfläche thermisch abgeschieden, ohne das Substrat in der Zwischenzeit einer oxidierenden Atmosphäre auszusetzen. Dann wird beispielsweise mit einem ein- oder mehrstufigen Sol Gel Vefahren oder mit einem CVD-Prozeß das ferroelektrische Material, z.B. Strontium-Wismut-Tantalat (SBT) oder Blei-Zirkonium-Titanat (PZT) abgeschieden und durch anschließende Temperschritte in die gewünschte ferroelektrische Phase gebracht. Nach dem Strukturieren des Materials werden Source und Drain implantiert und durch ein geeignetes Elektrodenmaterial kontaktiert.

Gleichzeitig wird mit diesem Elektrodenmaterial auch das ferroelektrische Material flächig kontaktiert, so daß Anschlüsse für Source, Drain und Gate entstehen.

Fig. 2 ist eine schematische Darstellung einer FEMFET-Vorrichtüng gemäß einer Ausführungsform der vorliegenden Erfindung.

In Fig. 2 bezeichnet zusätzlich zu den bereits eingeführten Bezugszeichen 60 eine dielektrische Pufferschicht.

Bei dieser zweiten Ausführungsform erfolgt das Aufbringen einer dielektrischen Pufferschicht 60 auf der Diffusionsbarrierenschicht 50. Dies hat den Vorteil, daß die Schicht unter dem Ferroelektrikum FE dicker gestaltet werden kann, aber die guten Eigenschaften des Siliziumnitrids, insbesondere auch das elektrische Verhalten aufgrund der Reihenschaltung der verschiedenen Kapazitäten, weiter verbessert oder zumindest nicht verschlechtert wird.

Durch eine dickere Schicht mit gleicher Kapazität kann die über dieser Schicht abfallende Spannung konstant gehalten werden und damit die Feldstärke, der diese Schicht ausgesetzt ist, reduziert werden.

Dadurch werden die Zuverlässigkeit und das elektrische Durchbruchsverhalten günstig beeinflußt. Dies ist möglich, da ein Oxid, wie z.B. CeO₂ eine 2,5-fach größere relative Dielektrizitätskonstante εᵣ = 20 - 25 als Siliziumnitrid besitzt und damit bei gleicher effektiver Kapazität dicker ausgeführt werden kann.

Obwohl die vorliegende Erfindung vorstehend anhand eines bevorzugten Ausführungsbeispiels beschrieben wurde, ist sie darauf nicht beschränkt, sondern auf vielfältige Art und Weise modifizierbar.

Beispielsweise ist die Reihenfolge der dielektrischen Pufferschicht und der Diffusionsbarrierenschicht derart umkehrbar, daß die dielektrische Pufferschicht auf dem Substrat aufgebracht wird und die Diffusionsbarrierenschicht darüber.

Auch kann ein Sandwichaufbau mit alternierenden dielektrischen Pufferschichten und Diffusionsbarrierenschichten gewählt werden.

Auch ist der Begriff Halbleitersubstrat im allgemeinen Sinne zu verstehen und kann sowohl monokristalline Wafersubstrate wie auch Wannensubstrate, Epitaxiesubstrate etc. bezeichnen.

Zur Reinigung des Substrats können alle Verfahren verwendet werden, die geeignet sind, das natürliche Oxid zu entfernen.

## Patentansprüche

1. FEMFET-Vorrichtung mit:
einem Halbleitersubstrat (10);
mindestens einem in dem Halbleitersubstrat (10) vorgesehenen Feldeffekttransistor (S, D, K, GS) mit einem Sourcebereich (S), einem Drainbereich (D), einem Kanalbereich (K) und einem Gatestapel (GS);
wobei
der Gatestapel (GS) zumindest eine ferroelektrische Schicht (FE) aufweist;
der Gatestapel (GS) zumindest eine dünne Diffusionsbarrierenschicht (50) aufweist, welche zwischen der untersten ferroelektrischen Schicht (FE) und dem Halbleitersubstrat (10) angeordnet ist und derart gestaltet ist, daß sie eine Ausdiffusion von Bestandteilen aus der oder den ferroelektrischen Schicht oder Schichten (FE) in das Halbleitersubstrat (10) im wesentlichen verhindert;
im Gatestapel (GS) mindestens eine dielektrische Pufferschicht (60) zwischen der ferroelektrischen Schicht (FE) und dem Halbleitersubstrat (10) vorgesehen ist; und
die Diffusionsbarrierenschicht (50) eine Siliziumnitridschicht mit einer Dicke im Bereich einiger Nanometer ist;
**dadurch gekennzeichnet, daß**
die dielektrische Pufferschicht (60) eine Oxidschicht mit einer Dielektrizitätskonstante im Bereich von 20 bis 25 ist; und
die dielektrische Pufferschicht (60) derart dicker als die Diffusionsbarrierenschicht (50) ist, daß sie diegleiche Kapazität aufweist wie die Diffusionsbarrierenschicht (50).

2. FEMFET-Vorrichtung nach Anspruch 2, **dadurch gekennzeichnet, daß** die Siliziumnitridschicht direkt auf dem Halbleitersubstrat (10) vorgesehen ist.

3. FEMFET-Vorrichtung nach Anspruch 1 oder 2, **dadurch gekennzeichnet, daß** die dielektrische Pufferschicht (60) direkt auf dem Halbleitersubstrat (10) vorgesehen ist.

4. FEMFET-Vorrichtung nach Anspruch 1, 2 oder 3, **dadurch gekennzeichnet, daß** ein Sandwichaufbau mit alternierenden dielektrischen Pufferschichten und Diffusionsbarrierenschichten vorgesehen ist.

5. FEMFET-Vorrichtung nach einem der Ansprüche 1 bis 4, **dadurch gekennzeichnet, daß** die keramische Oxidschicht aus CeO₂ ist.

6. Verfahren zur Herstellung einer FEMFET-Vorrichtung nach Anspruch 1, **dadurch gekennzeichnet, daß** das auf dem Halbleitersubstrat (10) befindliche natürliche Oxid in einem Ätzprozeß entfernt wird und die Siliziumnitridschicht danach in situ abgeschieden wird, ohne das Halbleitersubstrat (10) dazwischen einer oxidierenden Atmosphäre auszusetzen.

## Claims

1. FEMFET device, having
a semiconductor substrate (10);
at least one field-effect transistor (S, D, K, GS) which is provided in the semiconductor substrate (10) and has a source region (S), a drain region (D), a channel region (K) and a gate stack (GS);
the gate stack (GS) having at least one ferroelectric layer (FE);
the gate stack (GS) having at least one thin diffusion barrier layer (50) which is arranged between the bottom ferroelectric layer (FE) and the semiconductor substrate (10) and is configured in such a manner that it substantially prevents constituents from diffusing out of the ferroelectric layer or layers (FE) into the semiconductor substrate (10) ;
at least one dielectric' buffer layer (60) being provided in the gate stack (GS) between the ferroelectric layer (FE) and the semiconductor substrate (10); and
the diffusion barrier layer (50) being a silicon nitride layer with a thickness in the range of a few nanometres;
**characterized in that**
the dielectric buffer layer (60) is an oxide layer with a dielectric constant in the range from 20 - 25; and
the dielectric buffer layer (60) is thicker than the diffusion barrier layer (50) to such an extent that it has the same capacitance as the diffusion barrier layer (50).

2. FEMFET device as claimed in Claim 1, **characterized in that** the silicon nitride layer is provided directly on the semiconductor substrate (10).

3. FEMFET device as claimed in Claim 1 or 2, **characterized in that** the dielectric buffer layer (60) is provided directly on the semiconductor substrate (10).

4. FEMFET device as claimed in Claim 1, 2 or 3, **characterized in that** a sandwich structure with alternating dielectric buffer layers and diffusion barrier layers is provided.

5. FEMFET device as claimed in one of Claims 1 to 4, **characterized in that** the ceramic oxide layer is made from CeO₂.

6. Process for fabricating the FEMFET device as claimed in Claim 1, **characterized in that** the natural oxide which is present on the semiconductor substrate (10) is removed in an etching process, and the silicon nitride layer is then deposited in situ, without exposing the semiconductor substrate (10) to an oxidizing atmosphere between these steps.

## Revendications

1. Dispositif FEMFET comprenant :
un substrat semi-conducteur (10) ;
au moins un transistor à effet de champs (S, D, K, GS), prévu dans le substrat semi-conducteur (10), comprenant une région de source (S), une région de drain (D), une région de canal (K) et un empilement de grille (GS) ;
l'empilement de grille (GS) comprenant au moins une couche ferroélectrique (FE) ;
l'empilement de grille (GS) comprenant au moins une couche barrière de diffusion (50) fine disposée entre la couche ferroélectrique (FE) la plus inférieure et le substrat semi-conducteur (10) et qui est formée de telle façon qu'elle évite pour l'essentiel une diffusion de composants de la couche ferroélectrique ou des couches ferroélectriques (FE) dans le substrat semi-conducteur (10) ;
dans l'empilement de grille (GS) au moins une couche tampon (60) diélectrique étant prévue entre la couche ferroélectrique (FE) et le substrat semi-conducteur (10) ; et la couche barrière de diffusion (50) étant une couche de nitrure de silicium avec une épaisseur de l'ordre de quelques manomètres ;
**caractérisé en ce que**
la couche tampon diélectrique (60) est une couche d'oxyde avec une constante diélectrique de l'ordre de 20 à 25 ; et
la couche tampon diélectrique (60) est plus épaisse que la couche barrière de diffusion (50) de telle façon qu'elle présente la même capacité que la couche barrière de diffusion (50).

2. Dispositif FEMFET selon la revendication 2, **caractérisé en ce que** la couche de nitrure de silicium est prévue directement sur le substrat semi-conducteur (10).

3. Dispositif FEMFET selon la revendication 1 ou 2, **caractérisé en ce que** la couche tampon diélectrique (60) est prévue directement sur le substrat semi-conducteur (10).

4. Dispositif FEMFET selon la revendication 1, 2, ou 3 **caractérisé en ce qu'**on prévoit une construction en sandwich avec une alternance de couches tampon diélectriques et de couches barrière de diffusion.

5. Dispositif FEMFET selon une des revendications 1 à 4, **caractérisé en ce que** la couche d'oxyde céramique est du CeO₂.

6. Procédé de fabrication d'un dispositif FEMNET selon la revendication 1, **caractérisé en ce que** l'oxyde naturel se trouvant sur le substrat semi-conducteur (10) est retiré par un processus de gravure et la couche de nitrure de silicium est ensuite déposée in situ sans exposer entre temps le substrat semi-conducteur (10) à une atmosphère oxydante.
